Europäisches Patentamt

European Patent Office

Office européen des brevets

(19)

(11) **EP 1 158 563 A1**

(12) **EUROPEAN PATENT APPLICATION**

(43) Date of publication:
**28.11.2001 Bulletin 2001/48**

(51) Int Cl.⁷: **H01J 37/153**

(21) Application number: **00110849.7**

(22) Date of filing: **22.05.2000**

(84) Designated Contracting States:
**AT BE CH CY DE DK ES FI FR GB GR IE IT LI LU
MC NL PT SE**
Designated Extension States:
**AL LT LV MK RO SI**

(71) Applicant: **ADVANTEST CORPORATION**
**Shinjuku-ku, Tokyo 163-08 (JP)**

(72) Inventors:
• **Lanio, Stefan, Dr.**
  **85435 Erding (DE)**
• **Frosien, Jürgen, Dr.**
  **85521 Riemerling (DE)**

(74) Representative: **Tetzner, Michael, Dipl.-Ing. et al**
**Van-Gogh-Strasse 3**
**81479 München (DE)**

(54) **Particle beam system**

(57)    The invention relates to a particle beam system having a source for generating a particle beam, means for focussing the particle beam onto a specimen, means for correcting the chromatic aberration, means for detecting a signal generated by the particle beam, means for processing the data of the detecting means to generate an image of the specimen, the processing means being adapted to combine at least a first image of the specimen that is chromatically corrected in a first direction and a second image of the specimen that is corrected in a second direction to generate a chromatically corrected image in both directions. The means for correcting the chromatic aberration are adapted to correct the chromatic aberration in one direction and there are means for rotating the specimen from a first orientation in which the first image is taken to a second orientation in which the second image is taken.

Fig. 1

EP 1 158 563 A1

## Description

The invention relates to a particle beam system and a method for generating an image of a specimen with a particle beam system by reducing the chromatic aberration of the particle beam system.

Highest possible resolution is the target of all high resolution microscopes, inspection, lithography and micro-machining systems. Those instruments are used, e.g. in analytical applications and also in the production and process control of semiconductor devices. Especially, high resolution low voltage microscopes are used for process control and defect review. The resolution of low voltage microscopes and many other systems is limited by the chromatic aberration. The chromatic aberration is determined by

$$D_C = C_C \, \alpha \, \Delta E/E$$

with

$D_C$ = chromatic aberration disc diameter,
$C_C$ = chromatic aberration coefficient,
$\alpha$ = aperture angle,
$\Delta E/E$ = energy width.

To reduce or overcome chromatic aberration the following means and procedures are known in the art:

- One possibility is the application of lenses with extremely low chromatic aberration coefficients, like single pole lenses or combined magnetic/electrostatic retarding field lenses with short focal length. This however is limited, since chromatic aberration coefficient $C_C$ can be reduced only down to approximately f/2, in which f is the focal length of the objective lens.

- Another possibility is the integration of a monochromator into the beam path of the particle beam system, which reduces the energy width of the particle beam. However, a monochromator is a complex optical element, which is difficult to integrate into a beam path without causing interferences with the optical system. Additionally, it increases the length of the optical system, which increases the electron-electron interaction. The electron-electron interaction, however, is another severe limitation, especially in low voltage particle beam systems.

- As yet another possibility it was proposed to integrate a multipole corrector, which introduces the negative chromatic aberration coefficient of the objective lens. The resulting chromatic aberration of the system is accordingly reduced to zero. An example of such a multipole corrector was proposed by Scherzer and it consists of four stages of multipole elements in which two stages are combined electrostatic magnetic multipoles. However, such an aberration correction system has the following drawbacks:

1. the requirement of an extremely stable power supply for a large quantity of multipole elements regarding supply voltages and supply currents;

2. the increase in length of the optical system with the drawback mentioned above;

3. the very high mechanical alignment and adjustment requirements for the multipole elements.

Since monochromators and correctors are complex components, they have not been applied in commercial particle beam systems up to now.

- Finally, a last approach avoids the complexity of the aforementioned multipole correction systems by using only one correction element, which consequently corrects chromatic aberration in one direction only. A first image is aquired, then the correction element is rotated by 90° and a second image is taken. Rotation of the element can be accomplished either by mechanical rotation of the element or by changing the element's electric and magnetic excitation. The images are superimposed, e.g. using FFT techniques which extract the high resolution image formation (EP-A-0 500 179).

The drawback of this method is that the correction element of the electromagnetic field has to be rotated. Mechanical rotation is slow and the necessary precision within the column is difficult to obtain. Electric/magnetic switching of the element suffers from hysteresis effects, requires a certain settling time and will usually also introduce a shift of the image field between the two exposures due to parasitic dipole fields of the corrector.

The object of the invention is to reduce the chromatic aberration of the particle beam system in order to increase the spatial image resolution significantly.

According to the invention, this object is achieved by the features of claims 1, 6, 7 and 13.

Further embodiments of the invention are the subject matter of the subordinate claims.

According to a first embodiment of the invention, the particle beam system having

- a source for generating a particle beam,
- means for focussing the particle beam onto a specimen,
- means for correcting the chromatic aberration,
- means for detecting a signal generated by the particle beam,

- means for processing the data of the detecting means to generate an image of the specimen, the processing means being adapted to combine at least a first image of the specimen that is chromatically corrected in a first direction and a second image of the specimen that is corrected in a second direction to generate a chromatically corrected image in both directions.

The means for correcting the chromatic aberration are adapted to correct the chromatic aberration in one direction and, furthermore, there are means for rotating the specimen from a first orientation in which the first image is taken to a second orientation in which the second image is taken.

The method for generating an image of a specimen with a particle beam system by reducing the chromatic aberration of the particle beam system uses the following steps:

- exposing a specimen with the particle beam, the particle beam being chromatically corrected in one direction and
- generating a first image of the specimen in a first orientation,
- rotating the specimen from the first orientation to a second orientation,
- exposing the specimen with the particle beam, the particle beam being chromatically corrected in the same direction as before,
- generating a second image of the specimen in the second orientation
- and combining the two images to receive an image chromatically corrected in two directions.

According to a second embodiment of the invention, the particle beam system having at least a first and a second column, each column comprising

- a source for generating a particle beam,
- means for focussing the particle beam onto a specimen,
- means for correcting the chromatic aberration,
- means for detecting a signal generated by the particle beam.

Furthermore, there are means for moving the specimen from the first to the second column and the means for moving the specimen and said correcting means of each column being adapted to each other in that a first image of the specimen generated by the data of the detecting means of the first column is chromatically corrected in a first direction and a second image of the specimen generated by the data of the detecting means of the second column is chromatically corrected in a second direction.

Furthermore, there are means for processing at least the first image of the first column and the second image of the second column to generate an image that is chromatically corrected in at least two directions.

With respect to the second embodiment, it is possible to place the two columns in a common coordinate system and the correcting means of the first column is adapted to correct the chromatic aberration in a first direction in this coordinate system and the correcting means of the second column is adapted to correct the chromatical aberration in a second direction of this coordinate system.

However, it is also possible that the correcting means of both columns are adapted to correct the chromatic aberration in the same direction with respect to a common coordinate system while the moving means are adapted to rotate the specimen from a first to a second orientation when the specimen is moved from the first to the second column.

The method for generating an image of a specimen with a particle beam system comprising at least two columns, each column is adapted to expose the specimen with a particle beam which is chromatically corrected in one direction comprises the following steps:

- placing the specimen in the first column,
- exposing the specimen with the particle beam of the first column,
- generating a first image of the specimen that is chromatically corrected in a first direction,
- placing the specimen in the second column,
- exposing the specimen with the particle beam of the second column,
- generating a second image of the specimen that is chromatically corrected in a second direction and
- combining at least the first image of the first column with the second image of the second column to receive an image that is chromatically corrected in two directions.

Further embodiments and advantages of the invention are explained in greater detail below with reference to the drawings, in which

| Fig.1 | shows a schematical representation of a particle beam system according to a first embodiment of the invention, |
|---|---|
| Fig.2 | shows a schematic representation of the means for correcting the chromatic aberration, |
| Fig.3a - 3d | show images of the specimen with and without chromatic correction in the spatial domain, |
| Fig.4a - 4d | show images of the specimen with and without chromatic correction in the spatial frequency domain, |

Fig.5      shows a schematical representation of a particle beam system according to a second embodiment of the invention,

Figs.6-7      show three schematical representations of solutions according to the second embodiment of Fig.5.

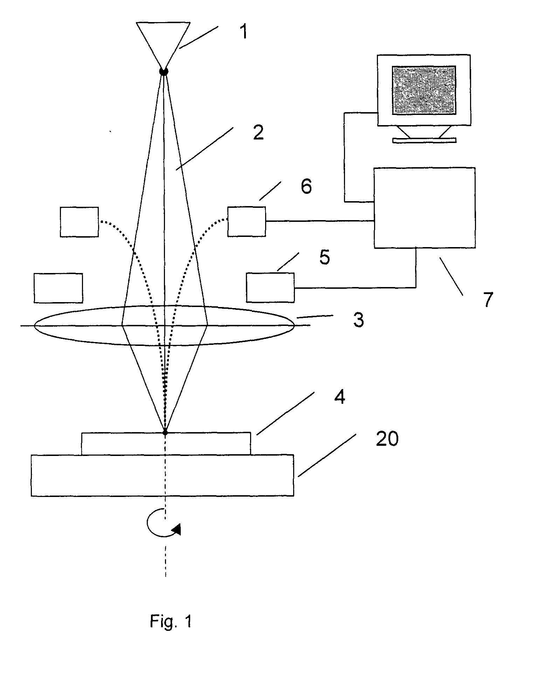

The particle beam system according to Fig.1 comprises a source 1 for generating a particle beam 2, means 3 for focussing the particle beam onto a specimen 4. Furthermore, there are means 6 for detecting a signal generated by the particle beam. In the disclosed embodiment, means 6 are adapted to detect backscattered and/or secondary particles.

A processing means 7 receives the output data of the detector means 6 in order to process the detector signal to generate the image of the specimen.

Other optical elements like apertures, deflectors, stigmators, blanker and other lenses are not shown for simplicity.

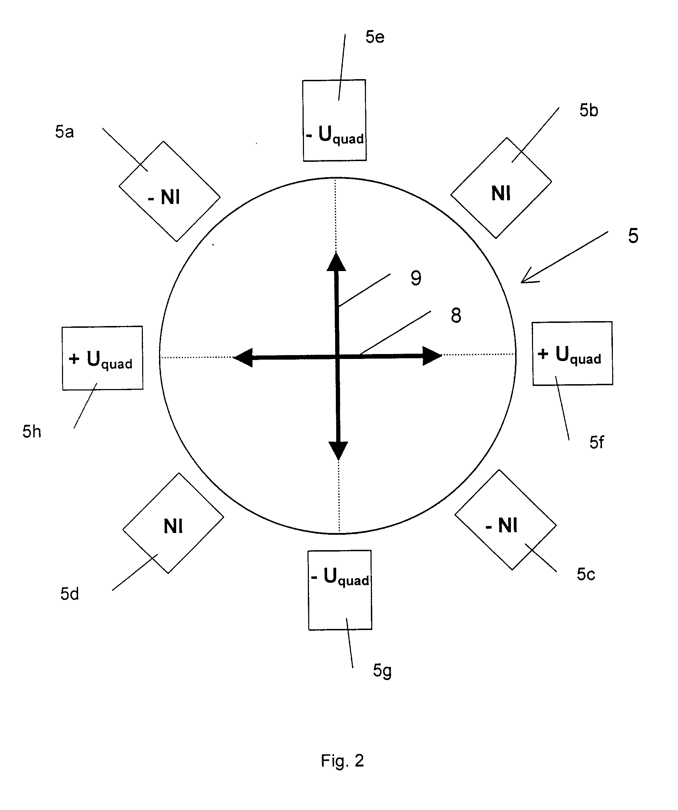

Means 5 for correcting the chromatic aberration will now be described in Fig.2 in more detail.

This correcting means is formed by an electrostatic magnetic quadrupole having four magnetic pole elements 5a - 5d and four electrostatic pole elements 5e - 5h for correcting the chromatic aberration.

Such an electrostatic magnetic quadrupole, in which the electrostatic and magnetic fields are orthogonal can be excited in such a way that there is no influence on the primary particle beam 2 having a certain primary energy. For energies, which differ from the primary energy by a certain amount, e.g. caused by energy widths, the electrostatic magnetic quadrupole has a dispersion for the off-axial beams, which has the same radial dependency as the chromatic aberration of particle beam lenses. The sign of the dispersion of the electrostatic magnetic quadrupole is in one direction negative, which means that a negative chromatic aberration can be introduced into the optical system. Accordingly, the chromatic aberration correction can be performed in one direction 8 by a suitable excitation of the electrostatic magnetic quadrupole. In the orthogonal direction 9, however, the electrostatic magnetic quadrupole introduces a contribution, which increases (doubles) the chromatic aberration of the optical system.

Correction means 5 is arranged preferably coaxially within or close to the focussing means.

Particle beam systems, especially scanning microscopes, also comprise deflection means for deflecting the particle beam in order to scan the specimen. Such a deflection means can be advantageously incorporated within the correction means 5 by applying additional variable voltages to the electrostatic pole elements 5e - 5h or by applying additional variable currents to the magnetic pole elements 5a - 5d. Accordingly, it will be possible to incorporate the correction means 5 without increasing the length of the optical system. By applying a multipole element with at least eight pole elements it would also be possible to incorporate a stigmator within the correction means 5.

The particle beam system according to Fig.1 further comprises means 20 for rotating the specimen 4 from a first orientation in which a first image is taken to a second orientation in which a second image is taken.

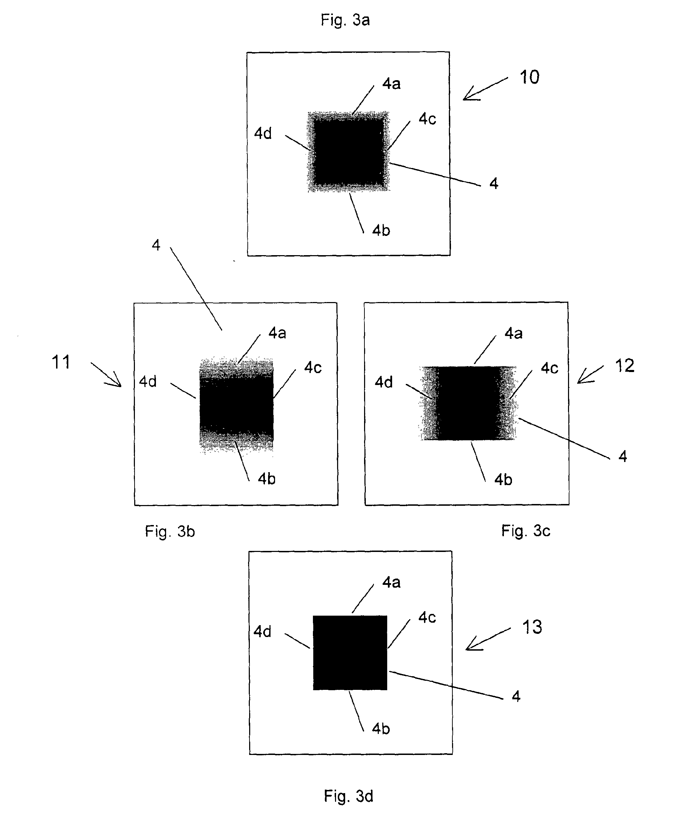

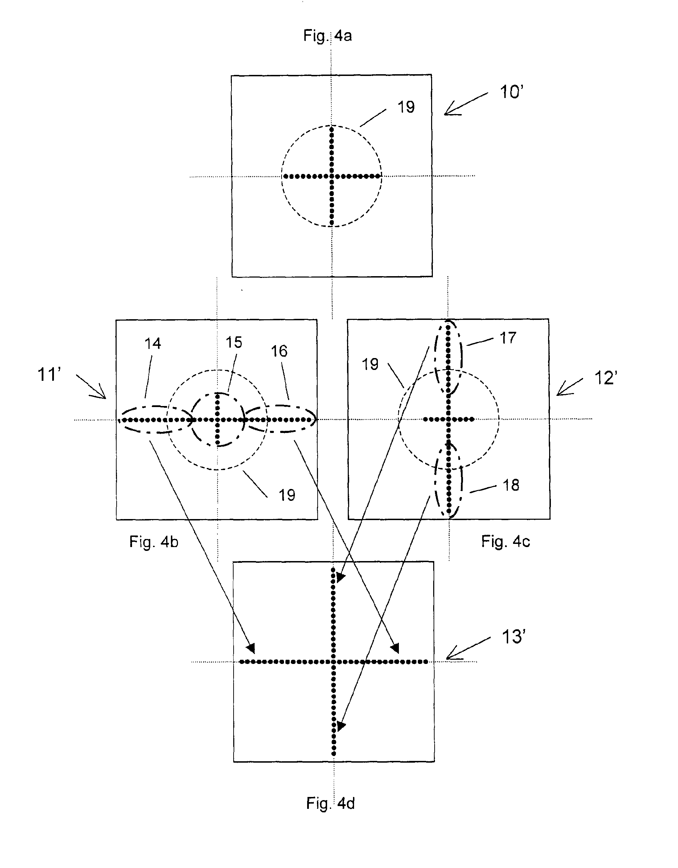

The method for generating an image of the specimen according to the invention will now be described in more detail with reference to Figs.3 and 4.

Figs.3a - 3d show images of the specimen in the spatial domain. Fig.3a discloses a chromatically non-corrected image 10 of the specimen 4. The specimen 4 is formed by a square element. Due to the chromatic aberration of the particle beam system, the edges 4a, 4b, 4c, 4d of specimen 4 are blurred.

In a first step the specimen 4 is placed in a first orientation within the particle beam apparatus and then the specimen 4 is exposed with the particle beam 2, the particle beam 2 being chromatically corrected in one direction 8. Due to the correction, two opposing edges 4c, 4d appear sharp while the other opposing edges 4a, 4b are even more blurred (Fig.3b).

Then, the specimen 4 is rotated by the rotating means from the first orientation to a second orientation. The angle of rotation is, for example, 90°. The specimen is exposed again with the particle beam being corrected in the same direction 8 as before. Due to the rotation of the element between the first and the second exposure, the opposing edges 4a, 4b of the second image 12 appear sharp, while the opposing edges 4c, 4d are even more blurred as compared to image 10. For a better demonstration of the correction effect images 11 and 12 have the same orientation, although specimen 4 was rotated before taking the second image 12.

After generating the first and second images 11, 12, both images will be combined to receive an image 13 which is chromatically corrected in both directions. As can be seen in Fig.3d, all edges 4a - 4d of the square specimen 4 appear sharp.

For the creation of the final chromatically corrected image 13, image transformation techniques are used, which transfer the image information from the spatial domain into the spatial frequency domain. In the spatial frequency domain the image is described not by pixel coordinates having a certian intensity, but by a spatial frequency distribution. The best known transformation is the Fourier Transformation.

Figs.4a - 4d show, in a simplified manner, the images according to Figs.3a - 3d in the spatial frequency domain.

Fig.4a shows the chromatically non-corrected image according to Fig.3a in the spatial frequency domain. Fig.4b corresponds to the 1st image 11 which is chromatically corrected in the x-direction. Accordingly, Fig.4b reveals a higher frequency spectrum in the x-direction. However, the image information in the y-direction is reduced. This is due to the fact that the electro-

static magnetic quadrupole element only cancels the chromatic aberration in one direction while it doubles the chromatic aberration in the other direction.

Fig.4c shows the spectrum of the image shown in Fig.3c. The spectrum of Fig.4c contains more information in the y-direction and less information in the x-direction.

Since the two images 11 and 12 are corrected in two directions x and y, each of them has a better spatial resolution in a different direction. Accordingly, the transformed images according to Figs.4b and 4c have a higher frequency spectrum in the two related directions. While Fig.4b contains higher frequencies in the x-direction (better spatial resolution in the x-direction), Fig.4c shows higher frequencies (better resolution) in the y-direction. By adding up the image information of both frequency images (Fig.4b, 4c) into one common image according to Fig.4d, all resolution information can be gathered within one image.

It should be noted that the spectrums of Figs. 4b and 4c contain common image information and information which is merely in Fig.4b or in Fig.4c. When combining the two spectra of Figs.4b and 4c, an image processing algorithm should be applied which takes into account that some image information is contained in both Figures.

In order to receive the corrected image 13' according to Fig.4d, it is necessary to combine at least the 1st and 2nd images 11', 12'according to Figs.4b and 4c. This may be achieved, for instance, by superimposing the dash-dotted areas 14, 15, 16 of Fig.4b with the dash-dotted areas 17, 18 of Fig.4c. The images 11, 12, however, have to be aligned before they will be combined. The alignment can also be performed by using Fourier transformation algorithms.

If the chromatically non-corrected image 10 according to Fig.3a is also generated, it may be possible to combine 1st and 2nd images 11, 12 and the chromatically non-corrected image 10 to generate the chromatically corrected image 13 according to Fig.3d. In this case, the chromatically non-corrected image 10 will also be transformed into an image 10' in the spatial frequency domain (cf. Fig.4a). In order to receive the spectrum 13' according to Fig.4d, spectra 10', 11', 12' may be combined in that the information within the dashed circle 19 of Fig.4a is added with the information outside the dashed circle 19 of Figs.4b and 4c.

The combined image 13' in the spatial frequency domain (= spectrum) will then be retransformed to the spatial domain which results in the image 13 according to Fig.3d.

By using image transformations, especially image transformation in the spatial frequency domain, e. g. the Fourier Transformation, it is much easier to combine the images to receive a chromatically corrected image.

It is preferred to use Fourier Transformations, as these transformations are well known and Fast Fourier Processors are available which can perform the above described routines easily.

Also the application of correlation algorithms and filter functions in the spatial frequency domain can be advantageously used when generating the chromatically corrected image. This implies that filtering and image processing can be very easily and very effectively performed in the spatial frequency domain.

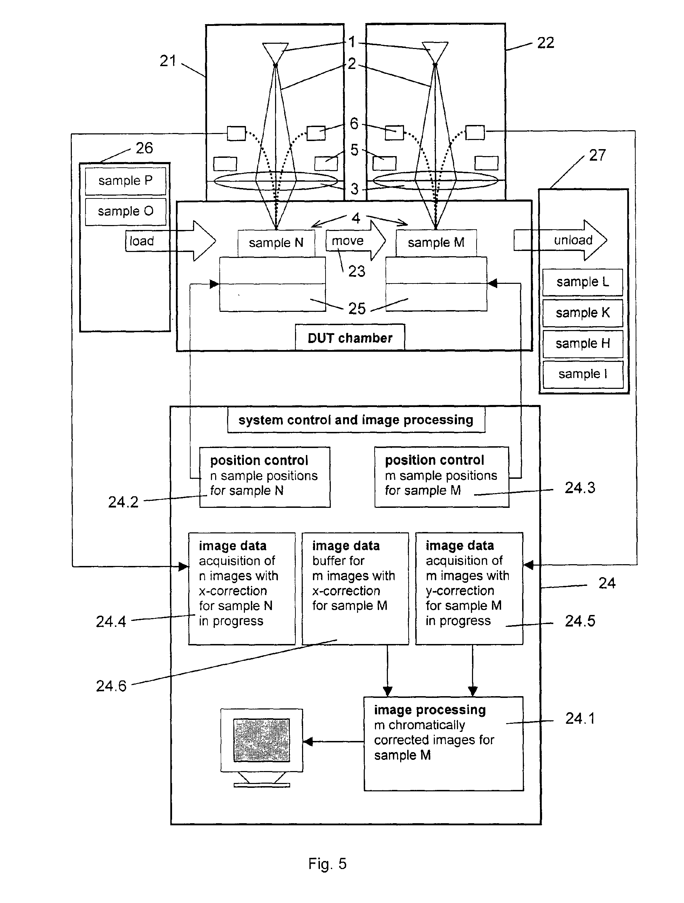

Fig.5 discloses a second embodiment of the invention, the particle beam system having at least a first and a second column 21, 22, each column comprising a source 1, means 3 for focussing the particle beam 2 onto a specimen 4, means 5 for correcting the chromatic aberration and means 6 for detecting a signal generated by the particle beam 2.

Furthermore, there are means 23 for moving the specimen 4 from the first column 21 to the second column 22.

Said means 23 for moving the specimen and said correcting means 5 of each column being adapted to each other in that a first image 11 of the specimen 4 generated by the data of the detecting means 6 of the first column 21 is chromatically corrected in a first direction and a second image 12 of the specimen 4 generated by the data of the detecting means 6 of the second column 22 is chromatically corrected in a second direction. In order to control the system and to process the images system control and image processing means 24 are provided. These system control and imaging processing means comprises means 24.1 for processing at least the first image of the first column 21 and the second image of the second column 22 to generate an image that is chromatically corrected in at least two directions.

In each column 21, 22 the specimen 4 is placed on a stage 25 which is movable in X-Y-directions.

The specimens or samples are loaded from a first storage 26 onto the stage 25 of the first column 21 while the preceding sample of column 21 is moved to the stage 25 of the second column 22. The preceding sample of the second column is unloaded and stored in a second storage 27. Accordingly, both columns 21, 22 are loaded at the same time and exposures can take place simultaneously.

Depending on the size of each specimen it will be necessary to take several images to cover the whole interesting area of specimen. Therefore, it will be necessary to move the stages 25 accordingly. The system control and imaging processing means 24 comprises position control means 24.2 for moving the stage 25 of the first column 21 and position control means 24.3 for moving the stage 25 of the second column 22.

The image data of each exposure are registered in image data registers 24.4 and 24.5. As each specimen will be exposed in the first column 21 and afterwards in the second column 22, it will be necessary to store the image data of the first exposure of this specimen in a buffer 24.6. Accordingly, buffer 24.6 stores the image data of the first image taken in the first column 21 and image data register 24.5 stores the image data of the second image of the same specimen. Image processing means 24.1 processes the image data of both images to generate an image that is chromatically corrected in at least two directions.

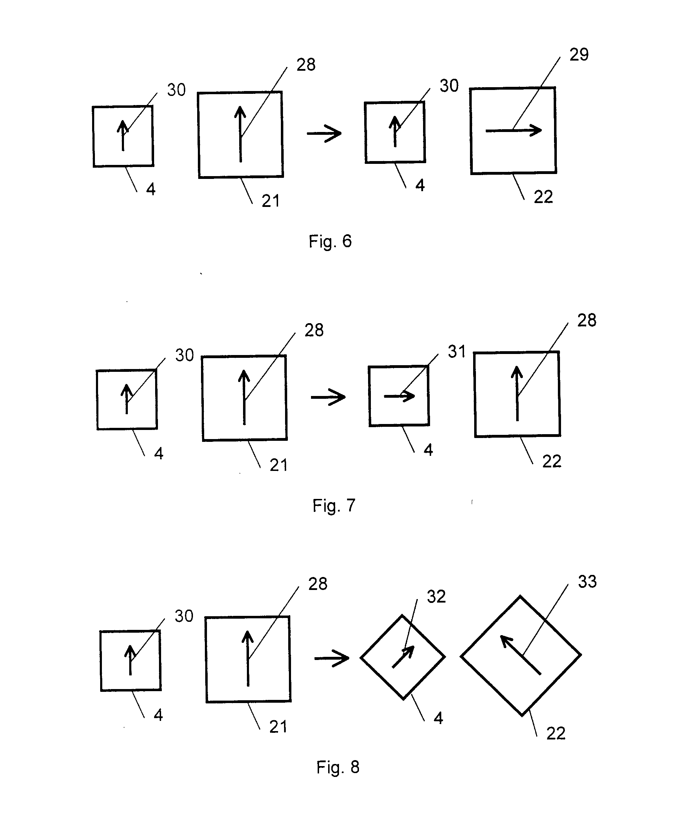

In order to achieve a first image of a specimen 4 which is chromatically corrected in a first direction and a second image of the same specimen which is chromatically corrected in a second direction there are three different solutions feasable which are disclosed in Figs. 6 to 8.

The particle beam system according to Fig.6 is characterised in that the two columns 21, 22 are placed in a common coordinate system and the correcting means of the first column 21 is adapted to correct the chromatical aberration in a first direction 28 in this coordinate system and the correcting means of the second column 22 is adapted to correct the chromatical aberration in a second direction 29 in this coordinate system. Accordingly, the specimen 4 can be placed in the first and second column 21, 22 with the same orientation 30. With such a system it will be possible to take a first image 11 of the specimen in the first column 21 and a second image 12 in the second column 22 whereby the two images are chromatically corrected in different directions.

Fig.7 discloses a different solution where the correcting means of both columns 21, 22 are adapted to correct the chromatic aberration in the same direction 28. In order to receive two images which are chromatically corrected in different directions, it will be necessary to rotate the specimen 4 from a first orientation 30 to a second orientation 31 as shown in Fig.7.

Of course it will also be possible to have a mixture of both solutions mentioned above. Such an embodiment is disclosed in Fig.8. In this embodiment, the correcting means of the two columns 21, 22 are adapted to correct the chromatic aberration in two different directions 28, 33. Furthermore, the specimen 4 is exposed in a first direction 30 in the first column 21 and is exposed in a second direction 32 in the second column 22.

The method for generating and processing the images of the specimen according to the second embodiment (Figs.5 to 8) was already described with reference to Figs.3 and 4.

The first embodiment according to Fig.1 as well as the second embodiment according to Figs.5 to 8 increase the spatial image resolution significantly. The correction means of the present invention do not have to be rotated and, accordingly, the alignment of all optical elements in the column is guaranteed. Additionally, it is much easier and less expensive to move and/or rotate the specimen than to rotate the correction means within the column.

By using two columns according to the second embodiment of the invention, the time to generate an image can be reduced even more.

The application of the invention is not limited to low voltage microscopy, but can also be applied in any kind of particle beam optics systems. This includes the application in both scanning beam systems and parallel beam imaging systems like transmission microscopes.

## Claims

1. Particle beam system having

   - a source (1) for generating a particle beam (2),

   - means (3) for focussing the particle beam onto a specimen (4),

   - means (5) for correcting the chromatic aberration,

   - means (6) for detecting a signal generated by the particle beam,

   - means (7) for processing the data of the detecting means to generate an image of the specimen, the processing means being adapted to combine at least a first image (11) of the specimen that is chromatically corrected in a first direction and a second image (12) of the specimen that is corrected in a second direction to generate a chromatically corrected image (13) in both directions,

   **characterised in that**

   - the means for correcting the chromatic aberration are adapted to correct the chromatic aberration in one direction (8) and

   - **in that** there are means (20) for rotating the specimen from a first orientation in which the first image is taken to a second orientation in which the second image is taken.

2. Particle beam system according to claim 1, **characterised in that** the means (20) for rotating the specimen (4) are adapted to rotate the specimen by an angle of 90° to change the orientation of the specimen from the first to the second orientation.

3. Particle beam system according to claim 1, **characterised in that** the means (5) for correcting the chromatic aberration is formed by at least one electrostatic magnetic multipole element.

4. Particle beam system according to claim 1, **characterised in that** the means (5) for correcting the chromatic aberration is formed by at least one electrostatic magnetic quadrupole element.

**5.** Particle beam system according to claim 1, **characterised in that** the means (5) for correcting the chromatic aberration also forms means for deflecting the particle beam.

**6.** Method for generating an image of a specimen with a particle beam system by reducing the chromatic aberration of the particle beam system, using the following steps:

- exposing a specimen (4) with the particle beam (2), the particle beam being chromatically corrected in one direction and

- generating a first image (11) of the specimen (4) in a first orientation,

- rotating the specimen (4) from the first orientation to a second orientation,

- exposing the specimen (4) with the particle beam (2), the particle beam being chromatically corrected in the same direction as before,

- generating a second image (12) of the specimen (4) in the second orientation

- and combining the two images to receive an image (13) chromatically corrected in two directions.

**7.** Particle beam system having at least a first and a second column (21, 22), each column comprising

- a source (1) for generating a particle beam (2),

- means (3) for focussing the particle beam onto a specimen,

- means (5) for correcting the chromatic aberration,

- means (6) for detecting a signal generated by the particle beam,

**characterised by**

- means (23) for moving the specimen from the first to the second column,

- said means (23) for moving the specimen (4) and said correcting means (5) of each column being adapted to each other in that a first image (11) of the specimen (4) generated by the data of the detecting means (6) of the first column (21) is chromatically corrected in a first direction and a second image (12) of the specimen (4) generated by the data of the detecting means (6) of the second column (22) is chromatically corrected in a second direction and

- means (24.1) for processing at least the first image (11) of the first column (21) and the second image (12) of the second column (22) to generate an image (13) that is chromatically corrected in at least two directions.

**8.** Particle beam system according to claim 7 **characterised in that** the two columns (21, 22) are placed in a common coordinate system and the correcting means (5) of the first column (21) is adapted to correct the chromatical aberration in a first direction (28) in this coordinate system and the correcting means (5) of the second column (22) is adapted to correct the chromatical aberration in a second direction (29) in this coordinate system.

**9.** Particle beam system according to claim 7 **characterised in that** the correcting means (5) of both columns (21, 22) are adapted to correct the chromatic aberration in the same direction (28) with respect to a common coordinate system and **in that** the moving means (23) are also adapted to rotate the specimen (4) from a first (30) to a second orientation (31) when the specimen (4) is moved from the first to the second column.

**10.** Particle beam system according to claim 7, **characterised in that** the means (5) for correcting the chromatic aberration is formed by at least one electrostatic magnetic multipole element.

**11.** Particle beam system according to claim 7, **characterised in that** the means (5) for correcting the chromatic aberration is formed by at least one electrostatic magnetic quadrupole element.

**12.** Particle beam system according to claim 7, **characterised in that** the means (5) for correcting the chromatic aberration also forms means for deflecting the particle beam.

**13.** Method for generating an image of a specimen with a particle beam system comprising at least two columns (21, 22), each column is adapted to expose the specimen (4) with a particle beam (2) which is chromatically corrected in one direction, the method is **characterised by** the following steps:

- placing the specimen (4) in the first column (21),

- exposing the specimen (4) with the particle beam (2) of the first column (21),

- generating a first image (11) of the specimen (4) that is chromatically corrected in a first direction,

- placing the specimen (4) in the second column (22),

- exposing the specimen (4) with the particle beam (2) of the second column (22),

- generating a second image (12) of the specimen (4) that is chromatically corrected in a second direction and

- combining at least the first image (11) of the first column (21) with the second image (12) of the second column (22) to receive an image (13) that is chromatically corrected in two directions.

**14.** Particle beam system according to claim 1 or 7 **characterised in that** the means (5) for correcting the chromatic aberration is formed by at least one electrostatic magnetic multipole element with at least eight pole elements which also forms a stigmator.

Fig. 1

5e

5a

- U_quad

5b

- NI

NI

5

9

8

+ U_quad

+ U_quad

5h

5f

NI

- NI

5d

5c

- U_quad

5g

Fig. 2

Fig. 3a

Fig. 3b

Fig. 3c

Fig. 3d

Fig. 4a

Fig. 4b

Fig. 4c

Fig. 4d

21

22

1

2

26

sample P

sample O

load

6

5

3

4

sample N — move → sample M

23

25

DUT chamber

27

unload

sample L

sample K

sample H

sample I

**system control and image processing**

**position control**
n sample positions
for sample N

24.2

**position control**
m sample positions
for sample M

24.3

**image data**
acquisition of
n images with
x-correction
for sample N
in progress

24.4

**image data**
buffer for
m images with
x-correction
for sample M

24.6

**image data**
acquisition of
m images with
y-correction
for sample M
in progress

24.5

24

**image processing**
m chromatically
corrected images for
sample M

24.1

Fig. 5

Fig. 6

Fig. 7

Fig. 8

**European Patent Office**

**EUROPEAN SEARCH REPORT**

Application Number

EP 00 11 0849

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,A | EP 0 500 179 A (PHILIPS NV) 26 August 1992 (1992-08-26) * abstract; figures * | 1,6,7,13 | H01J37/153 |
| A | US 3 795 813 A (KUNATH W) 5 March 1974 (1974-03-05) * column 6, line 55 - column 8, line 14; figure 6 * | 1,6,7,13 | |
| A | KOOPS H ET AL: "Test of an electron optical achromator" OPTIK, 1977, WEST GERMANY, vol. 48, no. 2, pages 225-236, XP000960802 ISSN: 0030-4026 * page 226, paragraph 3 - page 229 * | 1,6,7,13 | |
| A | SCHERZER: "Sphärische und chromatische Korrektur von Elektronen-Linsen" OPTIK,DE,JENA, 1947, pages 114-132, XP002090897 ISSN: 0863-0259 * page 116, paragraph 2 - page 117, last paragraph * | 1,6,7,13 | TECHNICAL FIELDS SEARCHED (Int.Cl.7) H01J |

The present search report has been drawn up for all claims

| Place of search | Date of completion of the search | Examiner |
|---|---|---|
| THE HAGUE | 16 November 2000 | Schaub, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 00 11 0849

This annex lists the patent family members relating to the patent documents cited in the above-mentioned European search report.
The members are as contained in the European Patent Office EDP file on
The European Patent Office is in no way liable for these particulars which are merely given for the purpose of information.

16-11-2000

| Patent document cited in search report | | Publication date | Patent family member(s) | | Publication date |
|---|---|---|---|---|---|
| EP 0500179 | A | 26-08-1992 | NL | 9100294 A | 16-09-1992 |
| | | | DE | 69210440 D | 13-06-1996 |
| | | | DE | 69210440 T | 07-11-1996 |
| | | | JP | 4328232 A | 17-11-1992 |
| | | | US | 5221844 A | 22-06-1993 |
| US 3795813 | A | 05-03-1974 | DE | 2213208 A | 04-10-1973 |